Europäisches Patentamt

European Patent Office

Office européen des brevets

(19)

(11) Publication number: **0 066 452**

A2

(12) **EUROPEAN PATENT APPLICATION**

(21) Application number: 82302708.1

(22) Date of filing: 26.05.82

(51) Int. Cl.³: **G 03 F 7/08**
**G 03 C 1/60**

(30) Priority: 27.05.81 JP 81389/81

(43) Date of publication of application:
08.12.82 Bulletin 82/49

(84) Designated Contracting States:
DE FR GB

(71) Applicant: KONISHIROKU PHOTO INDUSTRY CO. LTD.
No. 26-2, Nishishinjuku 1-chome Shinjuku-ku
Tokyo(JP)

(72) Inventor: Kurita, Yoshio
2196-592 Hirai
Hinodemachi Nishitama-gun Tokyo(JP)

(72) Inventor: Kita, Noriyasu
2-52-5 Ominami
Musashimurayama-shi Tokyo(JP)

(72) Inventor: Suzuki, Norihito
593 Naganumacho
Hachioji-shi Tokyo(JP)

(72) Inventor: Noguchi, Kazuo
1540-81 Kawaguchi-cho
Hachioji-shi Tokyo(JP)

(74) Representative: Ellis-Jones, Patrick George
Armine et al,
J.A. KEMP & CO. 14 South Square Gray's Inn
London WC1R 5EU(GB)

(54) Photosensitive composition for photosensitive printing plate.

(57) A photosensitive composition for photosensitive printing plates, containing a photosensitive diazo compound and an organic macromolecular carrier possessing improved storage stability and development properties by containing tartaric acid.

EP 0 066 452 A2

- 1 -

## PHOTOSENSITIVE COMPOSITION FOR PHOTOSENSITIVE PRINTING PLATE

This invention relates to a photosensitive composition for a photosensitive printing plate, particularly for a photosensitive lithographic printing plate. More particularly, it pertains to a stabilized diazo photosensitive composition.

It has been known that a photosensitive composition comprising a macromolecular compound and a diazo compound used as the photosensitive layer for a lithographic printing plate exhibits excellent performance such as excellent printing resistance without so-called "lacquering" (see Japanese Patent Publication No 7364/1977 and Japanese Provisional Patent Publication No 118802/1975).

However, a photosensitive printing plate having such a photosensitive layer on a support, after being stored for several months, perhaps due to too strong adhesion of the layer to a metal support, especially an aluminium plate subjected to an anodic oxidation treatment, can never be subjected to imagewise exposure, development and printing without suffering from the drawback of incomplete development at the unexposed portions, thereby causing such problems as scumming or, if not scummed, a deterioration in development causing a marked increase of the clear steps in the step tablet.

There is also known a method for overcoming this drawback by addition of an acid such as oxalic acid (Japanese Provisional Patent Publication No 3216/1978), but this method has not yet proved to be satisfactory.

The object of the present invention is to provide a photosensitive composition for a photosensitive printing plate having excellent storage stability. According to the present invention this is achieved by incorporating tartaric acid into a photosensitive composition, comprising a photosensitive diazo compound and an organic macromolecular carrier; this composition can be coated on a support to form a photosensitive printing plate.

Examples of the organic macromolecular carrier which can be used in the present invention include the following:

Homopolymer of a monomer having an aromatic hydroxyl group or copolymers of a monomer having an aromatic hydroxyl group with one or more other monomers. Such "monomers" include:

N-(4-hydroxyphenyl)acrylamide, N-(4-hydroxyphenyl)methacrylamide, N-(4-hydroxynaphthyl)methacrylamide (see Japanese Patent Publication No 34930/1977); o-, m- or p-hydroxystyrene and o-, m-, or p-hydroxyphenyl methacrylate.

Suitable "other monomers" which may be used include:

(1) $\alpha,\beta$-unsaturated carboxylic acids or anhydrides thereof such as acrylic acid, methacrylic acid, maleic acid anhydride;

(2) alkyl acrylates such as methyl acrylate, ethyl acrylate, propyl acrylate, butyl acrylate, amyl acrylate, hexyl acrylate, octyl acrylate, 2-chloroethyl acrylate, 2-hydroxyethyl acrylate, glycidyl acrylate or N-dimethylaminoethyl acrylate;

(3) alkyl methacrylates such as methyl methacrylate, ethyl methacrylate, propyl methacrylate, butyl methacrylate, amyl methacrylate, cyclohexyl methacrylate, 2-hydroxyethyl methacrylate, 4-hydroxybutyl methacrylate, glycidyl methacrylate or N-dimethylaminoethyl methacrylate;

(4) acrylamides or methacrylamides such as acrylamide, methacrylamide, N-methylolacrylamide, N-methylolmethacrylamide, N-ethylacrylamide, N-hexyl-methacrylamide, N-cyclohexylacrylamide, N-hydroxy-ethylacrylamide, N-phenylacrylamide, N-nitro-phenylacrylamide or N-ethyl-N-phenylacrylamide;

(5) vinyl ethers such as ethyl vinyl ether, 2-chloroethyl vinyl ether, hydroxyethyl vinyl ether, propyl vinyl ether, butyl vinyl ether, octyl vinyl ether or phenyl vinyl ether;

(6) vinyl esters such as vinyl acetate, vinyl chloroacetate, vinyl butyrate or vinyl benzoate;

(7) styrenes such as styrene, α-methylstyrene, methylstyrene or chloromethylstyrene;

(8) vinyl ketones such as methyl vinyl ketone, ethyl vinyl ketone, propyl vinyl ketone or phenyl vinyl ketone;

(9) olefins such as ethylene, propylene, isobutylene, butadiene or isoprene; and

(10) N-vinylpyrrolidone, N-vinylcarbazole, 4-vinylpyridine, acrylonitrile or methacrylonitrile.

There may also be employed other monomers copolymerizable with a monomer containing an aromatic hydroxyl group. The polymers to be employed in the present invention include polymers or resins obtained by partial esterification or etherification of aromatic hydroxyl groups such as of homopolymers or copolymers of the above monomers having aromatic hydroxyl groups,

- 4 -

or phenol novolacs. The structural units (monomers) having aromatic hydroxyl groups are preferably present in the above polymer in an amount of 1 to 80 mole %, more preferably 5 to 60 mole %, for storage stability and developability.

There may also be employed organic macromolecular carriers other than those mentioned above, including, for example, polyvinyl butyral resins, polyvinyl formal resins, shellac; multicomponent polymers comprising hydroxyalkyl acrylate units or hydroxyalkyl methacrylate units such as those obtained by polymerization of 2-hydroxyethyl methacrylate or acrylonitrile as disclosed in Japanese Provisional Patent Publication No 118802/1980; or multicomponent polymers obtained by polymerization of methyl methacrylate, acrylonitrile or methacrylic acid as disclosed in Japanese Provisional Patent Publication No 4144/1981. Such organic macromolecular carriers are generally incorporated in the photosensitive composition of the present invention preferably in an amount of 40 to 99% by weight, more preferably of 55 to 95% by weight.

The photosensitive diazo compound to be used in the present invention includes diazo resins, typically condensates between aromatic diazonium salts and, for example, active carbonyl containing compounds, particularly formaldehyde, among which a diazo resin soluble in an organic solvent is preferred.

As the diazo resins, there may be mentioned, for example, diazo resin inorganic salts which are reaction products soluble in an organic solvent of a condensate between p-diazodiphenylamine and formaldehyde or acetaldehyde with hexafluorophosphates or tetrafluoroborates  and the diazo resin organic acid salts soluble in an organic solvent which are reaction products of the aforesaid condensate with sulfonic acids such as p-toluenesulfonic acid or salts thereof, phosphinic acids such as benzenephosphinic acid or salts thereof, hydroxyl-containing compounds such as 2,4-dihydroxybenzophenone, 2-hydroxy-4-methoxybenzophenone-5-sulfonic acid or salts thereof, which have been disclosed in US Patent No 3 300 309.

The content of the photosensitive diazo compound in the photosensitive composition according to the present invention is preferably from 1 to 30% by weight, more preferably 3 to 15% by weight.

The content of tartaric acid in the photosensitive composition according to the present invention is preferably 0.1 to 20% by weight, more preferably 1 to 5% by weight for storage stability, developability, intensity at the image portion, printability and printing resistance.

The photosensitive composition according to the present invention may also contain, in addition to tartaric acid, other storage stabilizers as exemplified by high molecular weight organic acids as disclosed in Japanese Provisional Patent Publication No 107238/1981, halo-containing organic phosphoric acid compounds as disclosed in Japanese Provisional Patent Publication No 36207/1975, oxalic acid as disclosed in Japanese Provisional Patent Publication No 3216/1978, phosphoric acid as disclosed in Japanese Provisional Patent Publication No 151023/1979.

As the high molecular weight organic acids, there may be mentioned, for example, a polyacrylic acid, an acrylic acid copolymer, a polymethacrylic acid, a methacrylic acid copolymer and a novolac resin modified with a carboxylic acid.

- 6 -

Among them, a polyacrylic acid is preferable. The molecular weight of said high molecular weight organic acid is preferably 1 000 to 100 000, more preferably 5 000 to 30 000.

The content of said high molecular weight organic acid in the photosensitive composition according to the present invention is preferably 0.1 to 10% by weight, more preferably 1 to 5% by weight.

There may also be included various additives in the photosensitive composition according to the present invention to improve its performance. Examples of such additives are set forth below:

(1) alkyl ethers for improving coating characteristics;

(2) plasticizers for imparting flexibility and wear resistance to the coated layers;

(3) colorants for visualization of images; and

(4) optical color forming substances for visualization by exposure to light.

These additives are added generally in an amount of 0.5 to 30% by weight based on the total solids.

The photosensitive composition according to the present invention can be dissolved in a suitable solvent and the resultant photosensitive solution coated on a support such as an aluminum plate or other metal plate or metal-laminated film, followed by drying, to provide a photosensitive printing plate. The quantity of the coating is generally 0.5 to 6 $g/m^2$, dry basis. The support to be used (desirably aluminum plates, alumina-laminated films) is preferably applied with a graining treatment, anodic oxidation treatment or sealing treatment, such as with an aqueous sodium silicate solution.

- 7 -

The present invention is further illustrated in the following Examples.

EXAMPLE 1

An aluminum plate with a thickness of 0.24 mm was degreased by immersing it in an aqueous 20% sodium phosphate solution, and subjected to electrolytic etching in a 0.2 N HCl bath at a current density of $3A/m^2$, followed by anodic oxidation in a sulfuric acid bath. The anodic oxidation was effected to an amount of 3 $g/m^2$. Further, a sealing treatment was applied on the oxidized plate with an aqueous sodium metasilicate solution to obtain an aluminum plate for a lithographic printing plate.

On the aluminum plate, there was coated a Photosensitive solution - 1 having the composition shown below, by means of a rotary whirler. Then, the coated plate was dried at a temperature of 90°C for 2 minutes to obtain a Photosensitive lithographic printing plate - 1. Separately, for comparison, the same photosensitive solution as the Photosensitive solution - 1 but excluding tartaric acid was coated similarly as described above, on the same plate as used above, followed by drying, to obtain a Control sample.

(Photosensitive solution-1)

| | |
|---|---|
| Copolymer - 1 | 5.0 g |
| Diazo resin - 1 | 0.5 g |
| Tartaric acid | 0.2 g |
| Victoria Pure Blue BOH (produced by Hodagaya Kagaku Co Ltd) | 0.1 g |
| Methyl cellosolve | 100 ml |

In the above solution, the Copolymer - 1 had the composition (weight ratio): p-hydroxyphenyl methacrylamide/acrylonitrile/methyl methacrylate/ methacrylic acid = 20/35/35/10 and a molecular weight of 80 000; and the Diazo resin - 1 is a hexafluoro-phosphoric acid salt of a condensate between p-diazodiphenylamine and para-formaldehyde.

The resultant Photosensitive lithographic printing plate - 1 and the Control sample were subjected to imagewise exposure by a metal halide lamp Idolphin 2000 (produced by Iwasaki Denki Co Ltd) at an intensity of 4 mw/cm$^2$ for 60 seconds, developed with the Developer - 1 as shown below, to obtain a lithographic printing plate.

(Developer - 1)

| | |
|---|---|
| Benzyl alcohol | 50 mℓ |
| Solfit (produced by Kuraray Co., Ltd.) | 265 mℓ |
| Sodium carbonate | 5 g |
| Sodium sulfite | 5 g |
| Water | 1 liter |

For the Photosensitive lithographic printing plate, the storage stability and development properties were tested to give the results as shown in Table 1.

Table 1

| Type of photo-sensitive lith-graphic printing plate | Changes in number of clear steps depending on storage | | | |
|---|---|---|---|---|
| | 1 day | 3 days | 5 days | 10 days |
| Photosensitive lithographic printing plate - 1 | 0 | 0 | 0 | 0 |
| Control | 3 | scumming | scumming | scumming |

In the above Table, storage stability was tested by the following method. That is, the photosensitive lithographic printing plate - 1 and Control sample were stored at 40°C in an atmosphere of 80% humidity, exposed and developed with a developer. They were then compared with the Photosensitive lithographic printing plate - 1 and the Control sample which were subjected immediately after preparation to exposure and development to see the increased change in clear steps of the step tablet at the time of printing and the so-called scumming wherein printing ink is adhered to the non-image portions.

As can be seen from Table 1, the photosensitive composition according to the present invention possesses excellent storage stability and development properties.

EXAMPLE   2

In (Photosensitive solution - 1) in Example 1, 0.1 g of a polyacrylic acid (molecular weight: 12 000) was included, in otherwise the same manner as in Example 1, to prepare Photosensitive solution - 2.  A photosensitive lithographic printing plate - 2 according to the present invention was obtained similar to that in Example 1, and subjected similarly to exposure and development; it was found that it also possessed excellent storage stability and development properties similar to those in Example 1.

EXAMPLE   3

Photosensitive solution - 3 was prepared in the same manner as in Example 1 replacing the Copolymer - 1 with Copolymer - 2, and Photosensitive lithographic printing plate - 3 according to the present invention was obtained and subjected to exposure similar to Example 1. After exposure, the plate was developed using Developer - 2 in place of Developer - 1; it also possessed excellent storage stability and development properties similar to those in Example 1.

(<u>Developer - 2</u>)

| | | |
|---|---|---|
| Benzyl alcohol | 3 | parts |
| Sodium carbonate | 0.5 | part |
| Sodium sulfite | 0.5 | part |
| Sodium isopropylnaphthalene sulfonate | 1 | part |
| Water | 100 | parts |

In the above formulation, the Copolymer - 2 had the composition (weight ratio): 2-hydroxyethyl methacrylate/methyl methacrylate/acrylonitrile/methacrylic acid = 50/26.5/20/3.5 and a molecular weight of 56 000.

C L A I M S

1. A photosensitive composition containing a
photosensitive diazo compound and an organic macromolecular
carrier suitable for a photosensitive printing plate,
characterized in that it comprises tartaric acid.

2. A photosensitive composition according to
claim 1 wherein the content of the tartaric acid is 0.1 to
20% by weight based on the composition.

3. A photosensitive composition according to
claim 2 wherein the content of the tartaric acid is 1 to 5%
by weight based on the composition.

4. A photosensitive composition according to
any one of claims 1 to 3 wherein said organic macromolecular
carrier is a copolymer of a monomer having an aromatic
hydroxyl group with one or more other monomers.

5. A photosensitive composition according to
claim 4 wherein said monomer having an aromatic hydroxyl
group is   N-(4-hydroxyphenyl)acrylamide,  N-(4-hydroxyphenyl)methacrylamide, N-(4-hydroxynaphthyl)methacrylamide,
o-hydroxystyrene, m-hydroxystyrene, p-hydroxystyrene,
o-hydroxyphenyl methacrylate, m-hydroxyphenyl methacrylate
or p-hydroxyphenyl methacrylate.

6. A photosensitive composition according to
claim 4 or 5 wherein said other monomer(s) is an
$\alpha,\beta$-unsaturated carboxylic acid, an anhydride of an
$\alpha,\beta$-unsaturated carboxylic acid, an alkyl acrylate, an
alkyl methacrylate, an acrylamide, a methacrylamide, a
vinyl ether, a vinyl ester, a styrene, a vinyl ketone,
an olefin, an acrylonitrile or a methacrylonitrile.

7. A photosensitive composition according to any one of claims 4 to 6 wherein the structural units derived from said monomer having an aromatic hydroxyl group is present in said copolymer in an amount of 1 to 80 mole% based on the total structural units in said copolymer.

8. A photosensitive composition according to claim 7 wherein the structural units derived from said monomer having an aromatic hydroxyl group is present in said copolymer in an amount of 5 to 60 mole% based on the total structural units in said copolymer.

9. A photosensitive composition according to any one of the preceding claims wherein said photosensitive diazo compound is a diazo resin soluble in an organic solvent and obtainable by condensation of an aromatic diazonium salt with a compound containing an active carbonyl group.

10. A photosensitive composition according to claim 9 wherein said photosensitive diazo compound is a reaction product of a condensate of p-diazodiphenylamine and formaldehyde or acetaldehyde, with hexafluorophosphate or tetrafluoroborate, or a reaction product of the said condensate with a sulfonic acid, a phosphonic acid or a hydroxy-group-containing compound.

11. A photosensitive composition according to any one of the preceding claims wherein the content of said photosensitive diazo compound is 1 to 30% by weight based on the composition.

12. A photosensitive composition according to claim 11 wherein the content of said photosensitive diazo compound is 3 to 15% by weight based on the composition.

13. A photosensitive composition according to any one of the preceding claims which comprises in addition a high molecular weight organic acid.

14. A photosensitive printing plate which comprises a composition as claimed in any one of the preceding claims coated on a support.